# EUROPÄISCHE PATENTANMELDUNG

(11) **EP 4 651 264 A1**
(43) Veröffentlichungstag der Anmeldung: **19.11.2025**
(21) Anmeldenummer: 24175930.7
(22) Anmeldetag: 15.05.2024
(51) Int. Cl.: H01M 10/44, G01R 31/389, H01M 10/46, H01M 10/48, H02J 7/00

(54) **VERFAHREN ZUR FORMIERUNG EINER BATTERIEZELLE SOWIE VORRICHTUNG ZUR STEUERUNG EINER FORMIERUNG**

(71) Anmelder: Siemens Aktiengesellschaft, 80333 München (DE)
(72) Erfinder: Radinger, Hannes, 90459 Nürnberg (DE); Fischer, Michael, 91320 Ebermannstadt (DE); Katzer, Felix, 90763 Fürth (DE)
(74) Vertreter: Siemens Patent Attorneys

(57) **Zusammenfassung**

Es wird ein Verfahren zur Formierung einer Batteriezelle, insbesondere zur Ausbildung einer Feststoff-Elektrolyt-Grenzphase (SEI), bei dem eine zeitabhängige Stromstärke (1', 2', 3') und/oder Spannung zur Formierung der Batteriezelle verwendet wird, vorgeschlagen, wobei das Verfahren gekennzeichnet dadurch ist, dass ein komplexwertiger Zellinnenwiderstand (1, 2, 3) der Batteriezelle während der Formierung mehrfach erfasst wird, und die Steuerung der Stromstärke (1', 2', 3') und/oder der Spannung in Abhängigkeit des erfassten Zellinnenwiderstands (1, 2, 3) erfolgt.

Weiterhin betrifft die Erfindung eine Vorrichtung zur Steuerung einer Formierung einer Batteriezelle.

## Beschreibung

Die Erfindung betrifft ein Verfahren gemäß dem Oberbegriff des Patentanspruches 1 sowie eine Vorrichtung gemäß dem Oberbegriff des Patentanspruches 11.

Eine Formierung einer Batteriezelle ist einer der letzten Produktionsschritte in der Zellproduktion. Typischerweise erfolgt dieser Formierungsprozess nachdem die Zelle mit dem Elektrolyten befüllt und verschlossen wurde und bevor die Batteriezelle eingelagert und eine End-of-Line Qualitätskontrolle durchgeführt wird.

Der Formierungsprozess umfasst die ersten Lade- beziehungsweise Entladevorgänge der fertigen Batteriezelle und soll einen definierten und für die spätere Verwendung möglichst optimalen Ausgangszustand sicherstellen. Bei Lithium-Ionen-Zellen und verwandten Technologien wird durch die Formierung die Bildung einer wohldefinierten Feststoff-Elektrolyt-Grenzphase oder Festelektrolyt-Interphase (englisch: Solid Electrolyte Interphase; abgekürzt SEI) an der Oberfläche der Anode angestrebt. Diese bildet sich durch Reaktionen der Elektrode mit Elektrolyt-Additiven in bestimmten Spannungs- und gegebenenfalls Temperaturbereichen, die während der Entlade- beziehungsweise Ladevorgänge während des Formierungsprozesses durchlaufen werden.

Innerhalb einer Batteriezelle treten mehrere komplexe Reaktionen simultan auf, die sich in ihrer Reaktionskinetik voneinander unterscheiden. Hierbei ist jede elektrochemische Reaktion, insbesondere die Reaktionen, die zur SEI Formierung beitragen, abhängig vom Potential am Ort der Reaktion.

Somit kann es bei falsch eingestelltem zeitlichen Verlauf der vorgegebenen Stromstärke oder der angelegten Spannung dazu kommen, dass sich Potentiale an den Grenzflächen einstellen, die nicht für die Bildung der möglichst optimalen SEI geeignet sind, oder dass bereits weitere Reaktionen, beispielsweise ein Aufladen der Elektrodenmaterialien, beschleunigt stattfinden, die ihrerseits die SEI Formierung negativ beeinflussen. Es ist somit erforderlich, dass der Formierungsprozess geeignete Strom-, Spannungs- und/oder Temperaturverläufe zur Bildung der gewünschten SEI verwendet.

Weiterhin ist die Formierung einer der zeit- und energieintensivsten Prozesse in der Zellproduktion, sodass diese möglichst effizient sein müssen.

Die genannten technischen Anforderungen sowie die komplexen zugrundeliegenden chemischen Reaktionen stellen hohe technische Ansprüche an die Definition und Kontrolle der Prozessparameter während des Formierungsprozesses.

Bekannte Formierungsprozesse verwenden Stromstärken und gegebenenfalls Spannungs- und Temperaturverläufe basierend auf empirischen Tests an den produzierten Zellen beziehungsweise Batteriezellen. Dabei werden die Prozessparameter derart eingestellt, dass sie einen möglichst guten Kompromiss aus Performance und Prozesskosten darstellen. Falls Messungen zur Kontrolle des Formierungsprozesses verwendet werden, beschränken sich diese auf Strom- und Spannungsmessungen. Beispielsweise wird so lange zyklisiert, bis die gemessene differentielle Kapazität unter einen bestimmten Schwellenwert fällt. Dieses Verfahren erfordert eine möglichst genaue Kenntnis der verfügbaren Prozessfenster und kann dennoch die Streuungen in der Qualität der produzierten Zellen nicht vollständig reduzieren.

Der vorliegenden Erfindung liegt die Aufgabe zugrunde, die Formierung einer Batteriezelle, insbesondere im Rahmen ihres Herstellungsverfahren, zu verbessern.

Die Aufgabe wird durch ein Verfahren mit den Merkmalen des unabhängigen Patentanspruches 1 sowie durch eine Vorrichtung mit den Merkmalen des unabhängigen Patentanspruches 11 gelöst. In den abhängigen Patentansprüchen sind vorteilhafte Ausgestaltungen und Weiterbildungen der Erfindung angegeben.

Bei dem erfindungsgemäßen Verfahren zur Formierung einer Batteriezelle, insbesondere zur Ausbildung einer Feststoff-Elektrolyt-Grenzphase (SEI), wird eine zeitabhängige Stromstärke und/oder Spannung zur Formierung der Batteriezelle verwendet. Das erfindungsgemäße Verfahren ist gekennzeichnet dadurch, dass ein komplexwertiger Zellinnenwiderstand der Batteriezelle während der Formierung mehrfach erfasst wird, und die Steuerung der Stromstärke und/oder der Spannung in Abhängigkeit des erfassten Zellinnenwiderstands erfolgt.

Der Begriff des Steuerns umfasst vorliegend ebenfalls ein Regeln.

Die Batteriezelle ist insbesondere als Lithium-Ionen-Batteriezelle ausgebildet.

Der Zellinnenwiderstand ist grundsätzlich komplexwertig, das heißt dieser weist einen Realteil und einen Imaginärteil oder äquivalent einen Betrag und eine Phase auf. Grundsätzlich ist der Zellinnenwiderstand frequenzabhängig, sodass der Zellinnenwiderstand bei einen oder mehreren Frequenzen oder innerhalb eines festgelegten Frequenzbereiches erfasst wird.

Das erfindungsgemäße Verfahren kann bevorzugt im Rahmen eines Herstellungsverfahrens der Batteriezelle durchgeführt werden.

Gemäß der Erfindung wird der komplexwertige Zellinnenwiderstand (Realteil und/oder Imaginärteil oder Betrag und/oder Phase) zur Steuerung/Regelung der Formierung beziehungsweise zur Steuerung/Regelung der bei der Formierung verwendeten Stromstärke und/oder Spannung verwendet. Mit anderen Worten wird die Stromstärke und/oder Spannung in Abhängigkeit des erfassten komplexwertigen Zellinnenwiderstands gesteuert beziehungsweise geregelt. Hierzu wird erfindungsgemäß der komplexwertige Zellinnenwiderstand mehrfach während der Formierung der Batteriezelle erfasst.

Die Verwendung des komplexwertigen Zellinnenwiderstands ist insbesondere deshalb erfindungsgemäß vorgesehen, da sich dadurch im Wesentlichen das Ausbilden der SEI nachvollziehen lässt. Mit anderen Worten ändert sich der Zellinnenwiderstand mit dem SEI-Wachstum. Diese Änderung macht sich die Erfindung für die Steuerung/Regelung der Formierung zu nutze.

Die Erfindung weist einen oder mehrere der folgenden Vorteile auf:
- Der Formierungsprozess erfolgt für jede individuelle Batteriezelle optimiert, das heißt dieser ist an jede individuelle Batteriezelle angepasst.
- Es werden elektrische Kenngrößen aus einer Messung des Zellinnenwiderstands verwendet, um die Formierung zu steuern beziehungsweise zu regeln.
- Der Formierungsprozess kann durch niedrigere Ströme beschleunigt werden, wenn durch einen erhöhten Zellinnenwiderstand höhere Ströme erforderlich sind, um das Anodenpotential konstant zu halten, beziehungsweise toleriert werden können.
- Die Formierung kann verlangsamt werden, wenn der Formierungsprozess die Bildung der gewünschten SEI gefährden würde. Dadurch kann im Rahmen der Herstellung von Batteriezellen eine geringere Ausschussrate erreicht werden.
- Über die SEI-Signale der Messung des Zellinnenwiderstands kann die Formierungsdauer eingestellt werden. Hat die jeweilige Zelle zu einem früheren Zeitpunkt als der Median eine qualitativ hochwertige SEI ausgebildet, so kann die Formierung vorzeitig beendet werden, um so Zeit und Energie zu sparen.

Die erfindungsgemäße Vorrichtung zur Steuerung einer Formierung einer Batteriezelle, insbesondere zur Ausbildung einer Feststoff-Elektrolyt-Grenzphase (SEI), umfasst eine Steuereinheit und eine Messeinheit, wobei die Steuereinheit zur Steuerung einer zeitabhängigen Stromstärke und/oder Spannung zur Formierung der Batteriezelle ausgebildet ist. Die erfindungsgemäße Vorrichtung ist dadurch gekennzeichnet, dass die Messeinheit zur mehrfachen Erfassung eines komplexwertiger Zellinnenwiderstand der Batteriezelle während der Formierung ausgebildet ist, und die Steuereinheit dazu ausgebildet ist, die Stromstärke und/oder der Spannung in Abhängigkeit des erfassten Zellinnenwiderstands zu steuern.

Es ergeben sich zum erfindungsgemäßen Verfahren gleichartige, gleichwertige und gleichwirkende Vorteile und/oder Ausgestaltungen der erfindungsgemäßen Vorrichtung.

Gemäß einer vorteilhaften Ausgestaltung der Erfindung wird der Zellinnenwiderstand jeweils mittels einer elektrochemischen Impedanzspektroskopie erfasst.

Mit anderen Worten wird der jeweilige Zellinnenwiderstand beziehungsweise der jeweilige komplexwertige Wert des Zellinnenwiderstands während der Formierung der Batteriezelle mehrfach mittels einer elektrochemischen Impedanzspektroskopie (abgekürzt EIS) erfasst. Es wird somit mehrfach ein EIS-Spektrum erfasst. Dadurch wird die elektrochemische Impedanzspektroskopie zur zellspezifischen Steuerung/Regelung des Formierungsprozesses verwendet. Hierbei kann vorteilhafterweise im Rahmen eines Herstellungsverfahrens die individuelle Produktionshistorie berücksichtigt werden. Zudem kann das SEI Wachstum mittels der EIS-Messungen verfolgt werden.

In einer vorteilhaften Weiterbildung der Erfindung wird der Zellinnenwiderstand jeweils bei einer Frequenz im Bereich von 1 Kilohertz bis 10 Kilohertz erfasst.

Dadurch ergibt sich eine verbesserte Steuerung/Regelung des Formierungsverfahrens. Das ist deshalb der Fall, da die SEI-Ausbildung typischerweise mit Prozessen/Frequenzen im Bereich von 1 Kilohertz bis 10 Kilohertz in Zusammenhang steht.

Gemäß einer vorteilhaften Ausgestaltung der Erfindung wird der Zellinnenwiderstand während der Formierung in zeitlich regelmäßigen Abständen erfasst.

Dadurch wird eine vorteilhafte regelmäßige Überwachung der SEI-Ausbildung und eine entsprechend vorteilhafte Steuerung/Regelung des Verfahrens sichergestellt. Zur Messung des Zellinnenwiderstands kann bevorzugt die Stromstärke und/oder die Spannung abgeschaltet werden. Mit anderen Worten wird der Zellinnenwiderstand bevorzugt in stromlosen und/oder spannungslosen Zeitbereichen während der Formierung erfasst. Alternativ oder ergänzend ist eine Erfassung des Zellinnenwiderstandes in nicht stromlosen und/oder nicht spannungslosen Zeitbereichen während der Formierung vorgesehen.

In einer vorteilhaften Weiterbildung der Erfindung wird eine zur Formierung verbleibende Zeitdauer in Abhängigkeit des erfassten Zellinnenwiderstands gesteuert.

Mit anderen Worten wird die Zeitdauer der Formierung durch den Zellinnenwiderstand festgelegt. Hierbei kann eine verbleibende Zeitdauer ermittelt werden und/oder ein Abbruchkriterium in Abhängigkeit des Zellinnenwiderstands festgelegt werden. Dadurch wird vorteilhafterweise die Zeitdauer zur Formierung verwendet, die zur Ausbildung der vorteilhaften und vorgesehenen SEI erforderlich ist. Dies kann in Abhängigkeit der jeweiligen Zelle zu einer Verkürzung der Formierung führen, wodurch Zeit und Energie eingespart werden kann.

Gemäß einer vorteilhaften Ausgestaltung der Erfindung wird zur Steuerung der Zeitdauer der Zellinnenwiderstand bei einer Frequenz im Bereich von 1 bis 100 Hz, insbesondere im Bereich von 1 bis 10 Hz, erfasst.

Mit anderen Worten sind für die Steuerung der Zeitdauer niedrigere Frequenzen von Vorteil. Für die grundsätzliche Steuerung/Regelung des Formierungsprozesses sind hingegen höhere Frequenzen im Bereich von 1 kHz bis 10 kHz vorteilhaft. Hierbei wird besonders bevorzugt am Anfang des Formierungsprozesses der komplexe Zellinnenwiderstand bei Frequenzen im Bereich von 1 kHz bis 10 kHz erfasst. Zu einem späteren Zeitpunkt im Formierungsprozess wird der Zellinnenwiderstand dann alternativ oder ergänzend bei niedrigeren Frequenzen im Bereich von 1 bis 100 Hz zur Festlegung/Bestimmung der Zeitdauer erfasst.

Mit anderen Worten weist der Formierungsprozess wenigstens zwei Zeitbereiche auf, wobei innerhalb des ersten Zeitbereichs der Zellinnenwiderstand bei einer Frequenz im Bereich von 1 kHz bis 10 kHz erfasst wird und innerhalb des zweiten Zeitbereichs der Zellinnenwiderstand bei einer Frequenz im Bereich von 1 Hz bis 100 Hz erfasst wird. Innerhalb des zweiten Zeitbereichs kann ergänzend ein Erfassen innerhalb des Frequenzbereichs von 1 kHz bis 10 kHz vorgesehen sein.

In einer vorteilhaften Weiterbildung der Erfindung wird die Zeitdauer der Formierung durch ein Abbruchkriterium festgelegt, wobei die Formierung abgebrochen wird, wenn der Realteil und/oder Imaginärteil des erfassten Zellinnenwiderstands bei einer Frequenz und/oder innerhalb eines festgelegten Frequenzbereiches im Wesentlichen gleich einem festgelegten Soll-Realteil beziehungsweise Soll-Imaginärteil ist.

Mit anderen Worten wird vorteilhafterweise der Realteil und/oder Imaginärteil des Zellinnenwiderstands zur Steuerung der Zeitdauer herangezogen. Hierbei sind der erfasste Realteil und der Soll-Realteil im Wesentlichen gleich, wenn deren quadratische Abweichung kleiner oder gleich einem festgelegten Schwellenwert ist. Der Schwellenwert legt somit die Genauigkeit der Übereinstimmung fest. Dasselbe gilt analog für den Imaginärteil.

Gemäß einer vorteilhaften Ausgestaltung der Erfindung wird zur Erfassung des komplexwertigen Zellinnenwiderstands sein Realteil und/oder Imaginärteil erfasst.

Der Realteil des komplexwertigen Zellinnenwiderstands bildet den ohmschen Widerstand aus. Äquivalent zum Realteil und Imaginärteil können Betrag und/oder Phase des komplexwertigen Zellinnenwiderstands erfasst werden.

In einer vorteilhaften Weiterbildung der Erfindung wird die Stromstärke erhöht, wenn der Realteil des erfassten Zellinnenwiderstand unterhalb eines ersten festgelegten Schwellenwertes ist.

Dadurch wird vorteilhafterweise die SEI-Ausbildung verbessert. Das ist deshalb der Fall, da der Elektrodenpotentialverlauf während des Formierungsprozesses für jede Batteriezelle möglichst gleich sein sollte, da dies zu möglichst gleichen SEls der Batteriezellen führt. Hierbei ergibt sich das Elektrodenpotential einer graphitischen Elektrode beispielsweise über die Gleichung Φ_{Graphit} = Φ_{Graphit,OCP} + *η* = Φ_{Graphit,OCP} + *I ·* Re{*Z*}, wobei Φ_{Graphit,OCP} das Ruhepotential (OCP) und *η* die Überspannung bezeichnet. Die Überspannung *η* ist von der Stromstärke und vom Realteil des Zellinnenwiderstands (Impedanz) abhängig.

Gemäß einer vorteilhaften Ausgestaltung der Erfindung wird die Stromstärke reduziert, wenn der Realteil des erfassten Zellinnenwiderstand oberhalb eines zweiten festgelegten Schwellenwertes ist.

Dadurch wird vorteilhafterweise die SEI-Ausbildung weiter verbessert.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
- Figur 1: einen Ablauf eines Verfahrens gemäß einer Ausgestaltung der Erfindung; und
- Figur 2: ein Ermitteln der Zeitdauer einer Formierung gemäß einer Ausgestaltung der Erfindung;

Gleichartige, gleichwertige oder gleichwirkende Elemente können in einer der Figuren oder in den Figuren mit denselben Bezugszeichen versehen sein.

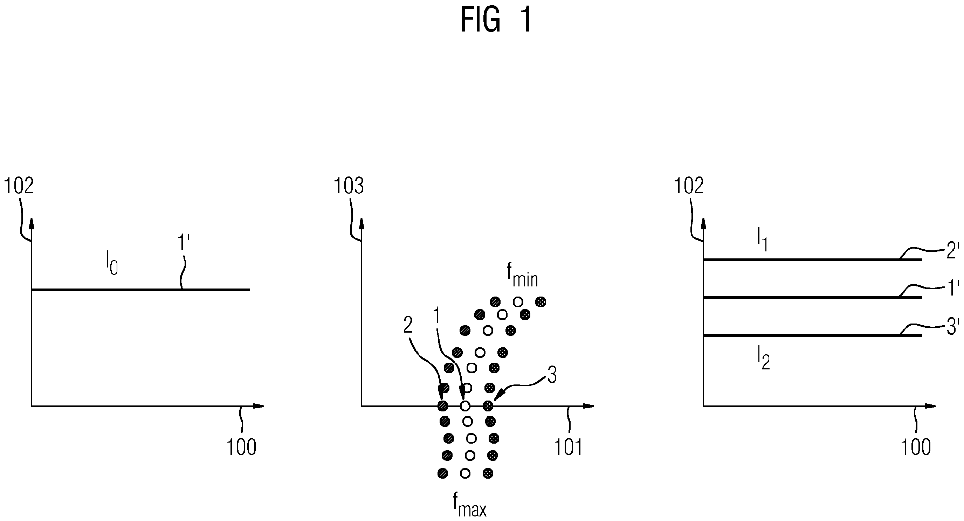

Die Figur 1 zeigt einen schematischen Ablauf eines Verfahrens beziehungsweise einen Zeitabschnitt des Verfahrens gemäß einer Ausgestaltung der Erfindung.

Das linke Diagramm zeigt den Verlauf einer initialen Stromstärke 1' mit welcher die Formierung gestartet wird. Hierbei ist an der Abszisse 100 des Diagramms die Zeit in beliebigen Einheiten aufgetragen. An der Ordinate 102 ist die Stromstärke in beliebigen Einheiten aufgetragen.

Nach dem Start der Formierung wird eine elektrochemische Impedanzspektroskopie (EIS-Messung) zur Erfassung des komplexwertigen Zellinnenwiderstands durchgeführt. In der Figur 1 ist dies im mittleren Diagramm für drei verschiedene Batteriezellen beispielhaft dargestellt. Hierbei ist an der Abszisse 101 des mittleren Diagramms der Realteil des Zellinnenwiderstands und an der Ordinate 103 der Imaginärteil des Zellinnenwiderstands in jeweils beliebigen Einheiten aufgetragen.

Das mittlere Diagramm zeigt drei verschiedene frequenzabhängige Verläufe des Zellinnenwiderstands 1, 2, 3. Hierbei entspricht jeder dargestellte Punkt den jeweils erfassten Zellinnenwiderstand bei einer bestimmten Frequenz. Der Zellinnenwiderstand wird somit jeweils für die drei Batteriezellen zwischen einer minimalen und maximalen Frequenz ermittelt, insbesondere zwischen 1 kHz und 10 kHz. Im mittleren Diagramm sind insbesondere die Realteile der Zellinnenwiderstände mit den Bezugszeichen 1, 2, 3 gekennzeichnet.

Das rechte Diagramm der Figur 1 zeigt die gemäß der Ausgestaltung der Erfindung vorgesehene Steuerung der Stromstärke in Abhängigkeit der erfassten Zellinnenwiderstände 1, 2, 3. Hierbei wird in der vorliegenden Ausgestaltung der Realteil des Zellinnenwiderstands 1, 2, 3 zur Steuerung herangezogen, wobei der Zellinnenwiderstand 1 einer Referenzzelle (englisch: Golden Sample) entspricht, das heißt dadurch ist wenigstens ein Soll-Realteil festgelegt.

Für die Batteriezelle 2 ist der Realteil ihres Zellinnenwiderstands 2 kleiner als der Soll-Realteil 1. Für die Batteriezelle 3 ist der Realteil ihres Zellinnenwiderstands 3 größer als der Soll-Realteil 1. Gemäß der vorliegenden Ausgestaltung wird somit die Stromstärke 2' gegenüber der initialen beziehungsweise Soll-Stromstärke 1' erhöht. Die Stromstärke 3' wird somit hingegen gegenüber der initialen beziehungsweise Soll-Stromstärke 1' verringert. Diese Änderung/Steuerung der jeweiligen Stromstärke ist mittels des rechten Diagramms der Figur 1 dargestellt.

Mit anderen Worten erfolgt somit zunächst eine Formierung der Batteriezelle mit einem Standard-Ladestrom 1'.

Anschließend wird in regelmäßigen zeitlichen Abständen der Zellinnenwiderstand, insbesondere der Ohm'sche Widerstand, über eine EIS-Messung überprüft beziehungsweise erfasst. Dafür werden der Real- und Imaginärteil der gemessenen Impedanz (Z) bei einer definierten Frequenz, beispielsweise im Bereich von 1 bis 10 kHz, verwendet.

Basierend auf der gemessenen Impedanz Z (Zellinnenwiderstand) wird der Ladestrom wie folgt gesteuert:
- Weist die Zelle einen kleineren Realteil 2 als der Soll-Realteil 1 auf, so wird die Stromstärke von 1' auf 2' erhöht.
- Weist die Zelle einen größeren Realteil 3 als der Soll-Realteil 1 auf, so wird die Stromstärke von 1' auf 3' reduziert.

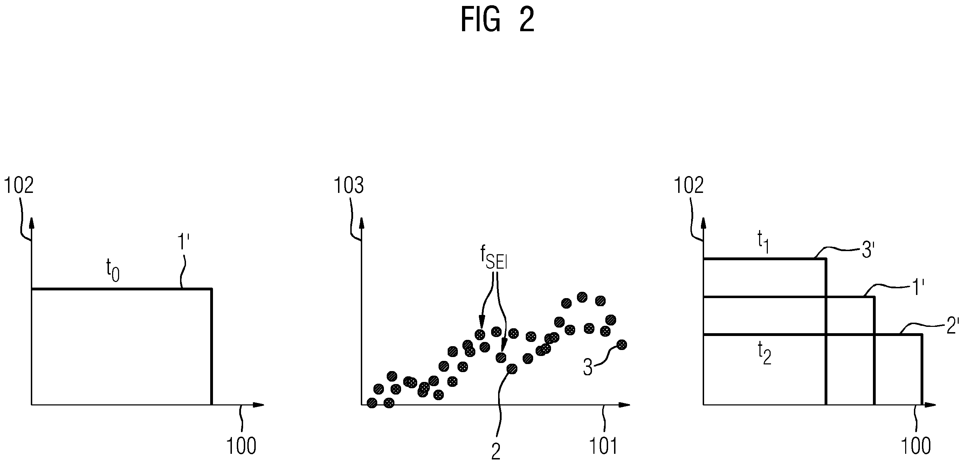

Die Figur 2 zeigt ein Ermitteln der Zeitdauer einer Formierung gemäß einer Ausgestaltung der Erfindung, insbesondere in einem späteren Verlauf der Formierung.

Mit anderen Worten wird im späteren Verlauf der Formierung die Aufnahme des EIS-Spektrums so angepasst, dass auch niedrigere Frequenzen, insbesondere im Bereich von 1 Hz bis 100 Hz, erfasst und verwendet werden. Hiermit wird wenigstens die Formierungsdauer gesteuert beziehungsweise geregelt, da ebenfalls die Dauer zur Bildung einer qualitativ hochwertigen SEI von Zelle zu Zelle variieren kann. Diese Steuerung/Regelung der Zeitdauer der Formierung ist exemplarisch in der Figur 2 dargestellt.

Die Figur 2 umfasst ein linkes, mittleres und rechtes Diagramm.

An der Abszisse 100 des linken und rechten Diagramms ist die Zeit in beliebigen Einheiten aufgetragen.

An der Ordinate 102 des linken und rechten Diagramms ist die Stromstärke in beliebigen Einheiten aufgetragen.

An der Abszisse 101 des mittleren Diagramms ist der Realteil des komplexwertigen Zellinnenwiderstands in beliebigen Einheiten aufgetragen.

An der Ordinate 103 des mittleren Diagramms ist der Imaginärteil des komplexwertigen Zellinnenwiderstands in beliebigen Einheiten aufgetragen.

Das mittlere Diagramm zeigt somit den frequenzabhängigen Verlauf des Zellinnenwiderstands in einem niedrigen Frequenzbereich, insbesondere im Bereich von 1 Hz bis 100 Hz.

Eine initiale Zeitdauer, die zu einer initialen Stromstärke 1' korrespondiert, ist aus dem linken Diagramm erkenntlich und ist ebenfalls mit dem Bezugszeichen 1' assoziiert.

In Abhängigkeit der erfassten Zellinnenwiderstände 2, 3 wird die Zeitdauer der Formierung gesteuert beziehungsweise angepasst. Dadurch ergeben sich die im rechten Diagramm dargestellte kürzere Zeitdauer 3' sowie die längere Zeitdauer 2'. Hierbei sind die Zeitdauern 2', 3' gegenüber der initialen Zeitdauer 1' länger beziehungsweise kürzer.

Mit anderen Worten wird zunächst eine initiale Formierungsdauer 1' festgelegt beziehungsweise angenommen, die sich aus einer definierten Stromstärke 1' bis zu einem bestimmten Spannungswert ergibt, und zunächst für alle Zellen verwendet wird. Für jede zu erreichende Spannungsgrenze kann dieses Verfahren (gegebenenfalls mehrfach) zur Steuerung/Regelung durchgeführt werden.

Gemäß der vorliegenden Steuerung/Regelung werden EIS-Spektren der Zellen erfasst, um die Bildung der SEI nachvollziehen zu können. Dafür werden die Z-Werte 2, 3 der jeweiligen Zellinnenwiderstände bei der charakteristischen Anregungsfrequenz der SEI, insbesondere im Bereich von 1 bis 100 Hz, verwendet.

Die Dauer der Formierung wird abhängig des Stadiums der Ausbildung der SEI basierend auf dem ermittelten Z-Wert 2, 3 angepasst. Hierzu wird dieser Wert 2, 3 mit einem Referenzwert 1 verglichen, um die verbliebene Dauer des Prozesses festzulegen. In Kombination mit der Verwendung des Zellinnenwiderstandes kann so nicht nur der Strom für den Formierungsprozess zellindividuell eingestellt, sondern vorteilhafterweise ebenfalls die Dauer des Formierungsprozesses bestimmt werden.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 1, 2, 3: Zellinnenwiderstand
- 1', 2', 3': Stromstärke/Zeitdauer

- 100: Abszisse (Zeit)
- 101: Abszisse (Realteil)
- 102: Ordinate (Stromstärke)
- 103: Ordinate (Imaginärteil)

## Patentansprüche

1. Verfahren zur Formierung einer Batteriezelle, insbesondere zur Ausbildung einer Feststoff-Elektrolyt-Grenzphase (SEI), bei dem eine zeitabhängige Stromstärke (1', 2', 3') und/oder Spannung zur Formierung der Batteriezelle verwendet wird, **gekennzeichnet dadurch, dass** ein komplexwertiger Zellinnenwiderstand (1, 2, 3) der Batteriezelle während der Formierung mehrfach erfasst wird, und die Steuerung der Stromstärke (1', 2', 3') und/oder der Spannung in Abhängigkeit des erfassten Zellinnenwiderstands (1, 2, 3) erfolgt.

2. Verfahren gemäß Anspruch 1, **gekennzeichnet dadurch, dass** der Zellinnenwiderstand (1, 2, 3) jeweils mittels einer elektrochemischen Impedanzspektroskopie erfasst wird.

3. Verfahren gemäß Anspruch 2, **gekennzeichnet dadurch, dass** der Zellinnenwiderstand (1, 2, 3) jeweils bei einer Frequenz im Bereich von 1 Kilohertz bis 10 Kilohertz erfasst wird.

4. Verfahren gemäß einem der vorhergehenden Ansprüche, **gekennzeichnet dadurch, dass** der Zellinnenwiderstand (1, 2, 3) während der Formierung in zeitlich regelmäßigen Abständen erfasst wird.

5. Verfahren gemäß einem der vorhergehenden Ansprüche, **gekennzeichnet dadurch, dass** eine zur Formierung verbleibende Zeitdauer in Abhängigkeit des erfassten Zellinnenwiderstands (1, 2, 3) gesteuert wird.

6. Verfahren gemäß Anspruch 5, **gekennzeichnet dadurch, dass** zur Steuerung der Zeitdauer der Zellinnenwiderstand (1, 2, 3) bei einer Frequenz im Bereich von 1 bis 100 Hz, insbesondere im Bereich von 1 bis 10 Hz, erfasst wird.

7. Verfahren gemäß Anspruch 5 oder 6, **gekennzeichnet dadurch, dass** die Zeitdauer der Formierung durch ein Abbruchkriterium festgelegt wird, wobei die Formierung abgerochen wird, wenn der Realteil und/oder Imaginärteil des erfassten Zellinnenwiderstands (1, 2, 3) bei einer Frequenz und/oder innerhalb eines festgelegten Frequenzbereiches im Wesentlichen gleich einem festgelegten Soll-Realteil ist.

8. Verfahren gemäß einem der vorhergehenden Ansprüche, **gekennzeichnet dadurch, dass** zur Erfassung des komplexwertigen Zellinnenwiderstands (1, 2, 3) sein Realteil und/oder Imaginärteil erfasst wird.

9. Verfahren gemäß einem der vorhergehenden Ansprüche, **gekennzeichnet dadurch, dass** die Stromstärke (1', 2', 3') erhöht wird, wenn der Realteil des erfassten Zellinnenwiderstands (1, 2, 3) unterhalb eines ersten festgelegten Schwellenwertes ist.

10. Verfahren gemäß einem der vorhergehenden Ansprüche, **gekennzeichnet dadurch, dass** die Stromstärke (1', 2', 3') reduziert wird, wenn der Realteil des erfassten Zellinnenwiderstands (1, 2, 3) oberhalb eines zweiten festgelegten Schwellenwertes ist.

11. Vorrichtung zur Steuerung einer Formierung einer Batteriezelle, insbesondere zur Ausbildung einer Feststoff-Elektrolyt-Grenzphase (SEI), umfassend eine Steuereinheit und eine Messeinheit, wobei die Steuereinheit zur Steuerung einer zeitabhängigen Stromstärke (1', 2', 3') und/oder Spannung zur Formierung der Batteriezelle ausgebildet ist, **dadurch gekennzeichnet, dass** die Messeinheit zur mehrfachen Erfassung eines komplexwertigen Zellinnenwiderstands (1, 2, 3) der Batteriezelle während der Formierung ausgebildet ist, und die Steuereinheit dazu ausgebildet ist, die Stromstärke (1', 2', 3') und/oder der Spannung in Abhängigkeit des erfassten Zellinnenwiderstands (1, 2, 3) zu steuern.
